Europäisches Patentamt

European Patent Office

Office européen des brevets

(11) Publication number: **0 453 684 A2**

# EUROPEAN PATENT APPLICATION

(21) Application number: 90311846.1

(22) Date of filing: 29.10.90

(51) Int. Cl.⁵: **H03B  5/16**

(30) Priority: 24.04.90 US 513758

(43) Date of publication of application:
30.10.91 Bulletin  91/44

(84) Designated Contracting States:
**DE FR GB NL**

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Strolle, Christopher Hugh**
**275 Bickley Road**
**Glenside, Pennsylvania 19038(US)**

(74) Representative: **Bubb, Antony John Allen et al**
**GEE & CO. Chancery House Chancery Lane**
**London WC2A 1QU(GB)**

(54) Playback equalizer for a tape recorder.

(57) An equalizer for a tape recorder has an integrator circuit (12) and a differentiator circuit (14) which receive as inputs the output signal from the playback head of the tape recorder. The output of the integrator circuit (12) and the output of the differentiator circuit (14) are applied to a subtractor circuit (16), the output of which is the equalized signal.

Fig.3.

EP 0 453 684 A2

This invention relates to a system for equalizing output signals from the playback head of a tape recorder.

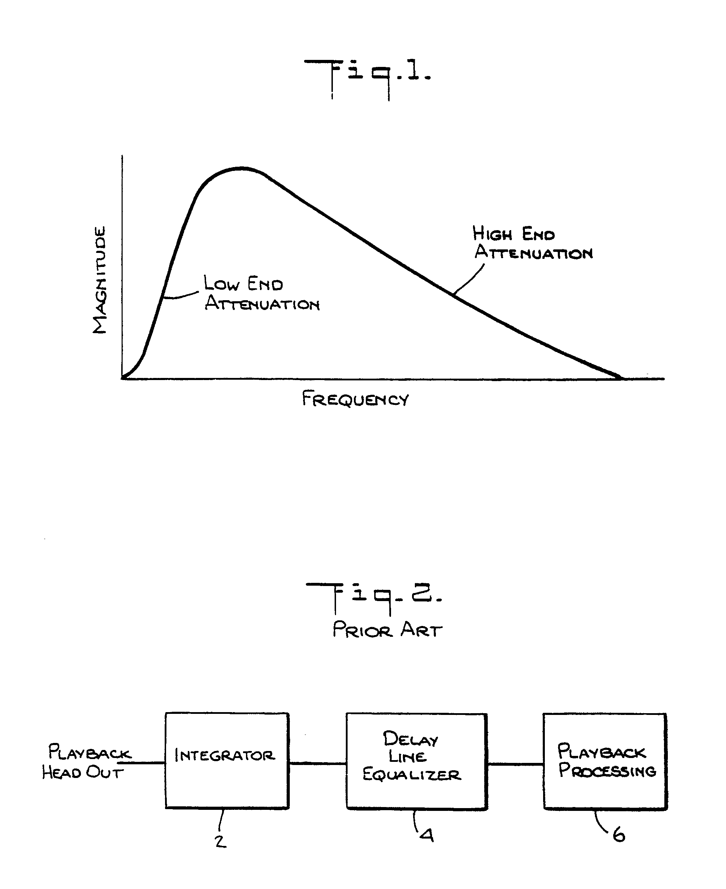

The objective of the playback system of a tape recorder is to accurately reproduce the original signal recorded on the tape. Due to the recording process and the characteristics of the playback head, the output signals produced by the playback head of a tape recorder for a constant input signal have, in general, magnitude/frequency characteristic such as illustrated in Fig. 1. The low frequency signal attenuation of the playback head output signal is caused by differentiation produced by the playback head. This differentiation is typically caused because the head reads changes in the magnetic field as the playback head passes the tape. High frequency signal attenuation is caused by rolloff produced by other playback head and tape characteristics. Another problem, not shown in Fig. 1, is that the differentiation which produces low frequency signal attenuation also produces a +90° phase shift in the signal. On the other hand, the high frequency signal attenuation has a linear phase and does not create a problem in reproducing the signal phase. To reproduce the input signal accurately, the output signal from the playback head must be equalized to boost the low and high frequency signals and to compensate for the +90° phase shift introduced by the system.

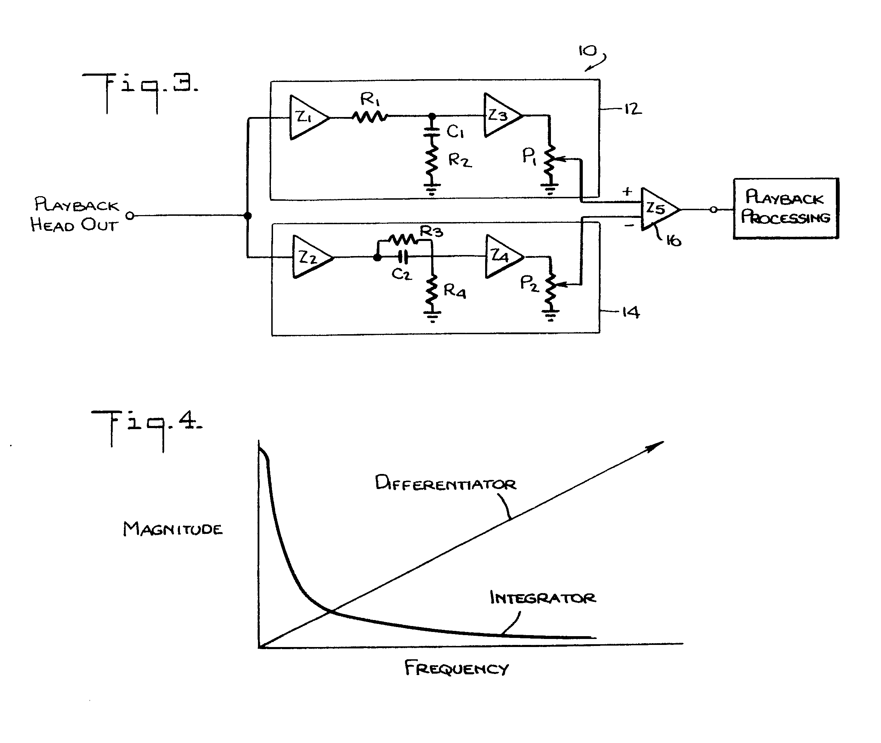

A typical prior art equalizer is illustrated in Fig. 2, and includes a sequential combination of an integrator 2 and delay line equalizer 4. In accordance with such prior art systems, the output signal from the playback head is applied to integrator 2 which boosts the low frequency signals and provides a -90° phase shift to the signal. The output from integrator 2 is then applied to delay line equalizer 4 (typically a delay line transverse filter) which has a linear phase and boosts the high frequency signals. The equalized signal output from delay line equalizer 4 is then applied to the other conventional playback processing system 6 in the tape recorder.

There are a number of problems associated with the use of the prior art equalizers described above. One of the problems is that a delay line transverse filter cannot be produced as an integrated circuit. Therefore, it is difficult to miniaturize this equalizer. Another problem is associated with the integrator. As noted above, the integrator must boost the low frequency signals and provide a -90° phase shift. While the integrator does boost the low frequency signals, it also attenuates the high frequency signals, thus adding to the problems associated with equalizing the signal from the playback head by further reducing the high frequency signals from the playback head. Therefore, the delay line equalizer must not only boost the high frequency signals which are output from the playback head, but also must produce additional correction for the high frequency signal attenuation introduced by the integrator.

Accordingly, it is an object of the present invention to overcome the problems in the prior art and to provide an improved equalizer for the signals from the playback head of a tape recorder which overcomes the problems in the prior art. A specific object of the invention is to provide an equalizer for analog or digital tape recorders which is low in cost and can be achieved on an integrated circuit chip.

In accordance with the invention, an equalizer for a tape recorder includes an integrator and differentiator, both responsive to the output signal from the playback head of the tape recorder, and a subtractor coupled to the outputs of the integrator and differentiator. The integrator boosts the low frequency signals and provides a -90° phase shift throughout the frequency range of interest. The differentiator boosts the high frequency signals and provides a phase shift of 90° throughout the frequency range of interest. The outputs from the integrator and differentiator are applied to the subtractor where the differentiator output is subtracted from the integrator output resulting in a signal having relatively constant amplitude over the frequency range of interest and a 0° phase shift in that frequency range.

These and other objects and features of the invention will now be described in conjunction with the drawings.

Fig. 1 is a graphical representation of the magnitude v. frequency characteristic of a typical signal output from the playback head of a tape recorder;

Fig. 2 is a block diagram representation of a prior art playback system for a tape recorder including an equalizer for equalizing the signal illustrated in Fig. 1;

Fig. 3 is a block diagram of a playback system for a tape recorder including an equalizer constructed in accordance with the invention; and

Fig. 4 is a graphical representation of the magnitude v. frequency characteristic of the individual circuit elements of the equalizer shown in Fig. 3.

Referring to Fig. 3, the output signal from the playback head is applied to equalizer circuit 10 including an integrator 12 and a differentiator 14. The outputs from integrator 12 and differentiator 14 are applied to a subtraction circuit 16. The output of subtraction circuit 16 is the equalized signal having a relatively constant magnitude and 0° phase shift over the frequency range of interest. That equalized signal is thereafter applied to the conventional playback processing system 18 of the tape recorder.

Fig. 4 illustrates the transfer characteristics of integrator 12 and differentiator 14. The integrator has a transfer characteristic, H(F), as a function of frequency equal to 1/F. The transfer characteristic H(F) of the differentiator as a function of frequency is: H(F) = F. In the desired frequency range of operation, differentiator 14 produces a constant phase shift of +90° in the signal from the playback head and integrator 12 produces a -90° phase shift in that signal.

The output of integrator 12 and differentiator 14 are combined in subtractor 16 with the output of integrator 12 being applied to the plus (+) terminal and the output of differentiator 14 being applied to the minus (-) terminal. At low frequencies, the output of integrator 12 predominates and the low frequency signals are increased. At high frequencies, the output of differentiator 14 predominates and the high frequency signals are increased. In the mid-range, the outputs of integrator 12 and differentiator 14 combine to reduce the magnitude of the signal to compensate for the relatively high mid-frequency signal from the playback head, as illustrated in Fig. 1. Furthermore, since the output of differentiator 14 is subtracted from the output of integrator 12, the +90° phase shift introduced by the differentiator is converted to a -90° phase shift which is in phase with the output of the integrator and produces a -90° phase shift for the equalizer throughout the entire frequency range of interest and compensates for the +90° phase shift in the output from the playback head. Thus, at the output of subtractor 16 is a signal which is an accurate representation of the original recorded signal.

In one specific implementation of the equalizer of the invention for use in a digital tape recorder, Z1, Z2, Z3 and Z4 are isolation amplifiers with unity gain, R1 and R3 equal 4 Kohms, C1 and C2 equal 100 picofarads and R2 and R4 equal 20 Ohms. Potentiometers P1 and P2 are optional and can be included to provide fine tuning for the signal without significantly affecting the phase response of the circuit. These potentiometers are selected and arranged to operate in providing a ratio of the differentiator and integrator output signals. Finally, Z5 is a subtracting differential amplifier. This equalizer is useful for the frequency range of approximately 400 KHz to 60 MHz.

While the presently preferred embodiment of the invention has been described, it will be apparent to those skilled in the art that this invention can be utilized in different ways and modification made to it while still coming within the scope of the invention. For example, the equalizer of this invention can be used for any type of tape recorder, whether digital or analog, with the only difference being a change in the circuit elements so that the desired equalizer characteristics are obtained for the particular frequency band of interest. Thus, the invention is not limited by the particular preferred embodiment described above but is set forth in the appended claims.

## Claims

1. An equalizer for a tape recorder for compensation for inaccuracies of the signal output from a playback head of a tape recorder and including an integrator circuit (12) responsive to the output signal from the playback head, characterised in that the equaliser further includes a differentiator circuit (14) that is also responsive to the output from the playback head and a subtracting circuit (16) for subtracting the output of the one circuit (14) from the output of the other circuit (12) to produce an equalizer output signal.

2. An equalizer as claimed in Claim 1 characterised in that the differentiator circuit (14) has a transfer function such that the high frequency components of the output signal from a playback head are increased.

3. An equalizer as claimed in Claim 1 or 2 characterised in that the integrator circuit (12) has a transfer characteristic such that the low frequency signals from the output signal from a playback head are increased.

4. An equalizer as claimed in any one of Claims 1-3 characterised in that the arrangement is such that the integrator circuit (12) provides a -90° phase shift to the output signal from a playback head of a tape recorder and the differentiator circuit (14) provides a 90° phase shift to the output signal from a tape recorder.

5. An equalizer for use in a tape recorder/playback system coupled to receive the output signal from the playback head of the tape recorder characterised in that it comprises a differentiator circuit (14) having a transfer characteristic which varies approximately directly as the frequency over the normal range of operation of the tape recorder, and which imparts approximately a +90° phase shift to the output signal from the playback head of the tape recorder, an integrator circuit (12) which has a transfer characteristic such that the magnitude of the output signal from the integrator varies approximately as a function of the inverse of the frequency of the input signal and which imparts approximately a -90° phase shift to the output signal from the integrator, means for applying the output signal from the playback head of the tape recorder to the inputs of both the differentiator circuit (14) and the integrator circuit (12), a subtractor circuit (16), means for applying the output signal from the integrator (12) to a positive terminal of the subtractor circuit (16), and means for applying the output signal from the differentiator (14) to a negative terminal of the subtractor circuit such that the output of the subtractor circuit is an equalized signal over the frequency range of operation of the tape recorder.

# Fig.1.

MAGNITUDE

Low End
Attenuation

High End
Attenuation

FREQUENCY

# Fig.2.
## PRIOR ART

PLAYBACK
HEAD OUT

INTEGRATOR

2

DELAY
LINE
EQUALIZER

4

PLAYBACK
PROCESSING

6

Fig.3.

Fig.4.